# EUROPEAN PATENT APPLICATION

(11) **EP 2 302 696 A2**
(43) Date of publication of application: **30.03.2011**
(21) Application number: 09015149.9
(22) Date of filing: 07.12.2009
(51) Int. Cl.: H01L 31/052

(54) **Concentrated photovoltaic module**

(30) Priority: 23.09.2009 TW 98217518 U
(71) Applicant: Everphoton Energy Corporation, Taipei 11493 (TW)
(72) Inventor: Chen, Yee Lee, Taipei 11493 (TW); Tsai, Chong Han, Taipei 11493 (TW)
(74) Representative: Manitz, Finsterwald & Partner GbR

(57) **Abstract**

A concentrated photovoltaic module includes a carrier, a plurality of side plates coupled to the carrier and having a plurality of openings, and a light-collecting unit having a lens assembly disposed above the carrier and a solar cell assembly disposed below the carrier. A receiving space is defined and formed by the carrier, the side plates, and the light-collecting unit. Water vapor, which might otherwise adversely affect photoelectric conversion taking place in the solar cell assembly when trapped inside the receiving space, is discharged from the receiving space through the openings, thereby reducing the possibility of damaging the solar cell assembly and prolonging the service life the photovoltaic module.

## Description

### BACKGROUND OF THE INVENTION

### 1. Field of the Invention

The present invention relates generally to power generation devices, and more particularly, to a concentrated photovoltaic module.

### 2. Description of Related Art

In conjunction with the rapid residential, commercial and industrial development, fossil fuels are gradually running out, and greenhouse gas emissions are becoming a global concern. Hence, providing a stable energy supply is becoming a global challenge. Compared with conventional coal-fired, gas-fired or nuclear power generation, solar cells directly convert solar energy into electricity through the photoelectric effect without generating any greenhouse gases or pollutants such as carbon dioxide, nitrogen oxides and sulfur oxides. Moreover, solar cells are helpful to reduce human beings' dependence on fossil fuels and provide safe, self-contained power sources.

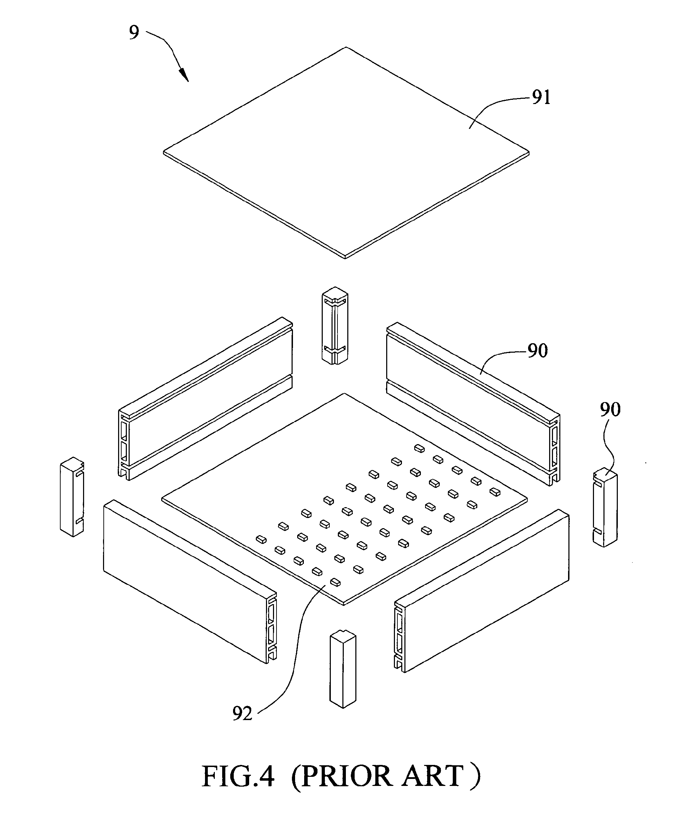

Referring to FIG. 4, a conventional concentrated photovoltaic module 9 at least comprises a hollow-shaped receiving unit 90, a lens 91 disposed on the receiving unit 90, and a solar cell assembly 92 disposed at the bottom of the receiving unit 90 and corresponding in position to the lens 91. When the sun is shining thereon, the lens 91 focuses the sunlight on the solar cell assembly 92, thereby outputting electric energy.

The receiving unit 90 of the conventional concentrated photovoltaic module 9 is hermetically sealed to prevent foreign bodies or dust from entering the receiving unit 90. However, water vapor left behind in the receiving unit 90 during the assembly process ends up being confined in the receiving unit 90, and can thereby compromise the photoelectric conversion otherwise enabled by the solar cell assembly 92, thereby reducing the conversion efficiency and shortening the service life of the concentrated photovoltaic module.

Therefore, it is imperative to overcome this drawback of the prior art, that is, the failure to prevent water vapor from compromising photoelectric conversion.

### SUMMARY OF THE INVENTION

To overcome the above drawback, the present invention provides a concentrated photovoltaic module, which comprises: a carrier formed of a plurality of rods connected with each other, the rods defining a plurality of side areas, a top area and a bottom area of the carrier; a plurality of side plates covering the side areas, respectively, and coupled to the carrier, the side plates having a plurality of openings; and a light-collecting unit comprising a lens assembly disposed above the carrier and a solar cell assembly disposed below the carrier and corresponding in position to the lens assembly, a receiving space being defined and formed by the light-collecting unit and the side plates such that sunlight is focused on the solar cell assembly by means of the lens assembly and air is discharged from the receiving space through the openings of the side plates. Preferably, the solar cell assembly is further provided with a plurality of through holes.

Preferably, the side areas, the top area, and the bottom area of the carrier are of a rectangular shape.

According to an embodiment, the lens assembly has a plurality of concave portions and the corresponding rods have a plurality of protruding portions for engaging with the concave portions. Alternatively, the lens assembly has a plurality of protruding portions and the corresponding rods have a plurality of concave portions for engaging with the protruding portions.

The rods are extruded aluminum rods, and the side plates are made of plastic.

Each of the openings has at least a bend, and the bend has a sag for preventing incoming dust from reaching the receiving space. Since the side plates are made of plastic, the total weight of the concentrated photovoltaic module can be reduced and the bend-equipped openings can be easily formed. Each of the openings has a dust collector, and each of the openings is covered with a filtering member.

The concentrated photovoltaic module is further provided with a plurality of through holes, wherein each of the through holes has at least a bend, and the bend has a sag for preventing incoming dust from reaching the receiving space. Each of the through holes has a dust collector.

Each of the through holes is covered with a filtering member.

The photovoltaic module further comprises a heat-dissipating member disposed below the solar cell assembly.

According to the present invention, water vapor is discharged from the receiving space through the openings of the side plates or the through holes of the solar cell assembly to thereby prevent the photoelectric conversion taking place in the solar cell assembly from being adversely affected by the water vapor otherwise present in the receiving space, thereby reducing the possibility of damage to the solar cell assembly and prolonging the service life of the concentrated photovoltaic module.

### BRIEF DESCRIPTION OF DRAWINGS

FIGS. 1A and 1B are a perspective diagram and an exploded diagram of a concentrated photovoltaic module of the present invention, respectively;
FIGS. 2A and 2B are partial exploded diagrams showing rods and a light-collecting unit of the concentrated photovoltaic module of FIGS 1A, 1B;
FIGS. 3A, 3B and 3C are partial sectional diagrams of the concentrated photovoltaic module according to different embodiments of the present invention; and
FIG. 4 is an exploded diagram showing a conventional concentrated photovoltaic module.

### DETAILED DESCRIPTION OF PREFERRED EMBODIMENTS

The following specific embodiments are provided to illustrate the disclosure of the present invention. These and other advantages and effects will be apparent to those skilled in the art after reading the disclosure of this specification.

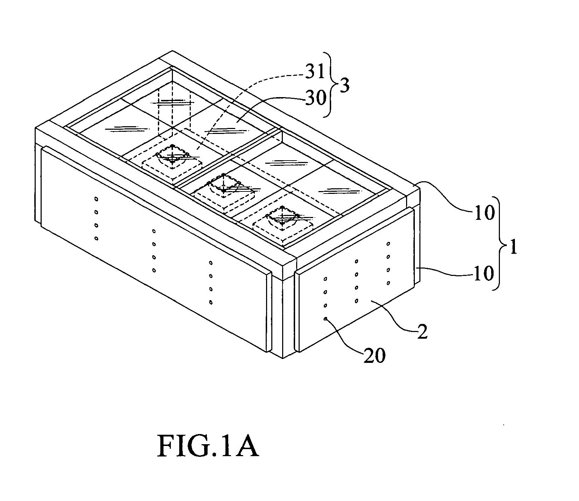

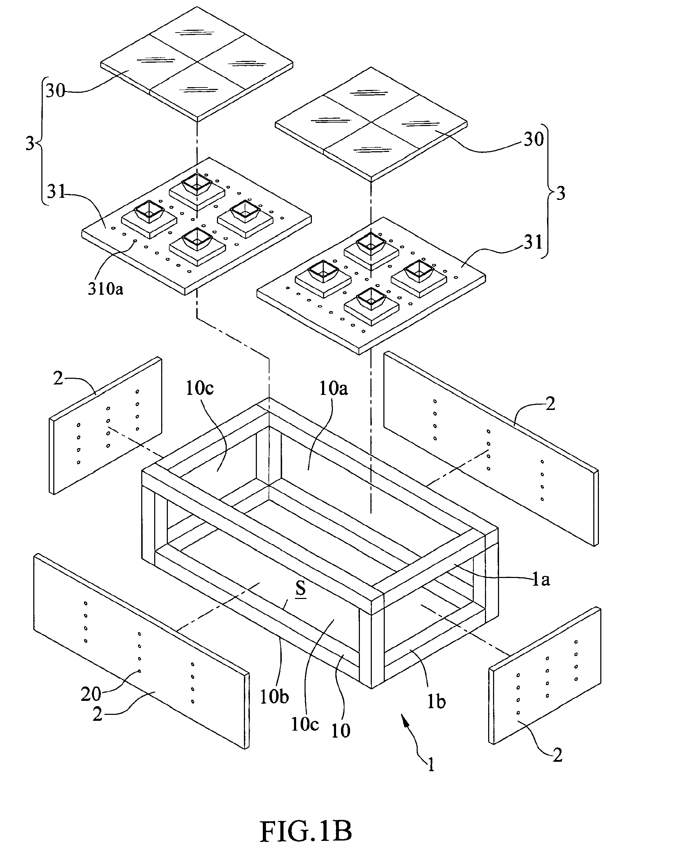

Referring to FIGS. 1A and 1B, a concentrated photovoltaic module according to the present invention comprises: a carrier 1 formed from a plurality of rods 10 connected to each other, a plurality of side plates 2 coupled to the carrier 1, and at least one light-collecting unit 3 comprising a lens assembly 30 and a solar cell assembly 31 and connected to the carrier 1.

The rods 10 of the carrier 1 define a plurality of side areas 10c to be covered by the side plates 2, a top area 10a to be covered by the lens assembly 30, and a bottom area 10b to be covered by the solar cell assembly 31. The rods are made of aluminum or an alloy thereof. The surface of the rods 10 is subjected to sandblasting, anodizing or electrodeposition coating.

The side plates 2 are coupled to the rods 10 to thereby cover the side areas 10c, respectively. The side plates 2 are further formed with a plurality of openings 20 which penetrate the side plates 2. In addition, the side plates 2 are made of plastic, and are adhered to, screwed to, or engaged with the rods 10 so as to be fixed in position to the carrier 1. In the present embodiment, the side plates 2 made of plastic weigh less than the carrier 1 made of aluminum, thereby reducing the total weight of the photovoltaic module.

In the present embodiment, the carrier 1 is configured to carry two said light-collecting units 3, by being topped with two said lens assemblies 30 covering the top area 10a and bottomed with two said solar cell assemblies 31 covering the bottom area 10b and corresponding in position to the lens assemblies 30, respectively. Thus, a receiving space S is defined and formed by the carrier 1, the light-collecting units 3 and the side plates 2. Sunlight is focused on the solar cell assemblies 31 by means of the lens assemblies 30. Air enters and exits the receiving space S via the openings 20.

In the present embodiment, the carrier 1 is a hexahedron, as the side areas 10c, the top area 10a, and the bottom area 10b are of a rectangular shape. The rods 10 form an upper frame 1a for carrying the lens assemblies 30 and a lower frame 1b for carrying the solar cell assemblies 31. The lens assemblies 30 cover the top area 10a, and the solar cell assemblies 31 cover the bottom area 10b. Four said side plates 2 provided between the upper frame 1a and the lower frame 1b are configured to cover the four adjacent side areas 10c, respectively. Hence, the lens assemblies 30, the solar cell assemblies 31, and the side plates 2 together define a hermetically sealed receiving space S. In other embodiments, the carrier 1 can be of other shapes.

In the present embodiment, the openings 20 are formed in the side plates 2 to penetrate the side plates 2, and thus water vapor can be discharged from the receiving space S. Since water vapor can be discharged from the receiving space S through the openings 20, photoelectric conversion taking place in the solar cell assembly 31 is unlikely to be adversely affected by the water vapor otherwise present in the receiving space S, thereby reducing the possibility of damaging the solar cell assembly.

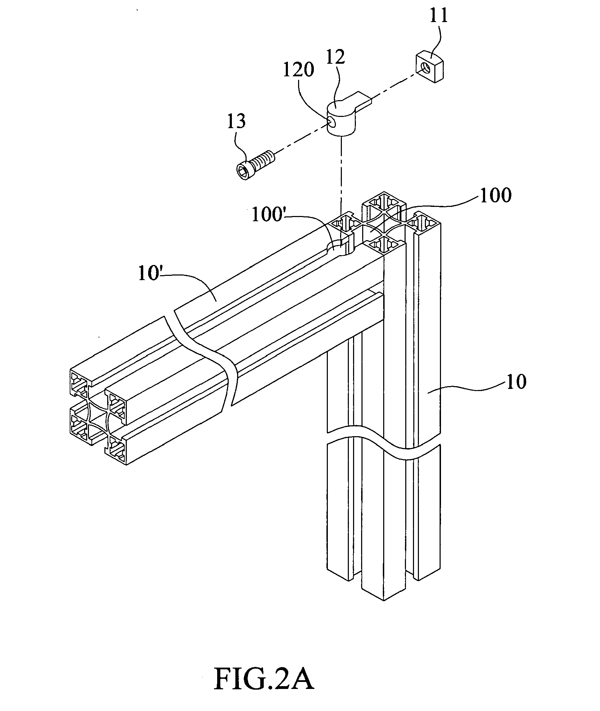

FIG. 2A shows a way of connecting two rods 10, 10' together. In the present embodiment, two said rods 10, 10' are aluminum extruded rods. Two said rods 10, 10' are adjacent and perpendicular to each other, and are each provided with a plurality of slots 100, 100' extending inward from the surface of each of two said rods 10, 10'. A nut 11 is disposed in one of the slots 100 of the rod 10, while a fixing member 12 having a penetrating hole 120 is disposed in one of the slots 100' of the rod 10'. A bolt 13 is passed through the penetrating hole 120 of the fixing member 12 to engage with the nut 11, thereby fastening together two said rods 10, 10' that are adjacent and perpendicular to each other. It should be noted that various ways of fastening two said rods 10, 10' together exist and are well known in the art, and the above-described disclosure refers to one of the conventional ways of fastening.

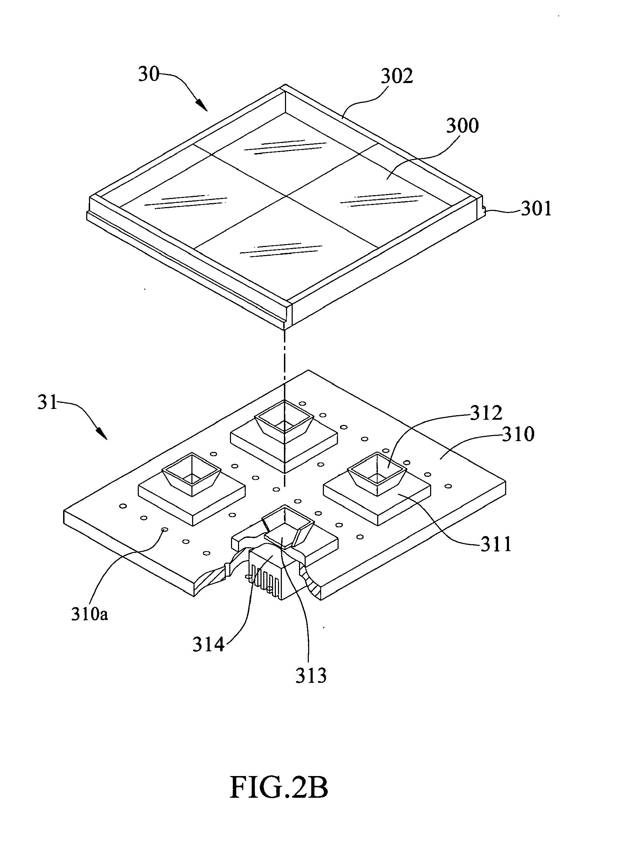

FIG. 2B is a partial exploded diagram of the light-collecting unit 30. The lens assembly 30 has a Fresnel lens 300 and a plurality of protruding portions 301 capable of being inserted into the slots 100 for the lens assembly 30 to be positioned on the rods 10. In other embodiments, the lens assembly 30 may have concave portions, wherein the rods 10 have corresponding protruding portions for engaging with the concave portions. Moreover, the lens assembly 30 and the rods 10 can be assembled by adhering the lens assembly 30 to the rods 10, rather than inserting the protruding portions 301 into the slots 100. Referring to FIGs. 1B and 2B, the Fresnel lens 300 can be directly integrated with a piece of glass instead of being connected with a piece of glass through a frame 302 as shown in FIG. 2B. The lens assembly 30 can have a different structure and still serve the same purpose as disclosed in the present invention; hence, the lens assembly 30 is not herein described in detail.

The solar cell assembly 31 comprises: a plate member 310 disposed on the carrier 1 and having a plurality of through holes 310a; a plurality of insulating substrates 311 disposed on the plate member 310; a plurality of light gathering members 312 disposed on the insulating substrates 311, respectively; a plurality of solar cells 313 disposed inside the light gathering members 312 on the insulating substrates 311, respectively; and a plurality of heat-dissipating members 314 disposed below the solar cells 313, respectively. Light beams leaving the lens assembly 30 are focused on the solar cells 313 by means of the light gathering members 312. It should be noted that the light-collecting unit 3 of the present invention may come in different forms and dimensions as disclosed in the prior art and is not regarded as an essential technical feature of the present invention; hence, the light-collecting unit 3 is not herein described in detail.

The through holes 310a of the solar cell assembly 31 are configured for removal of air such that photoelectric conversion taking place in the solar cell assembly 31 is unlikely to be adversely affected by water vapor, thereby efficiently reducing the risk of damage occurring to the solar cell assembly 31.

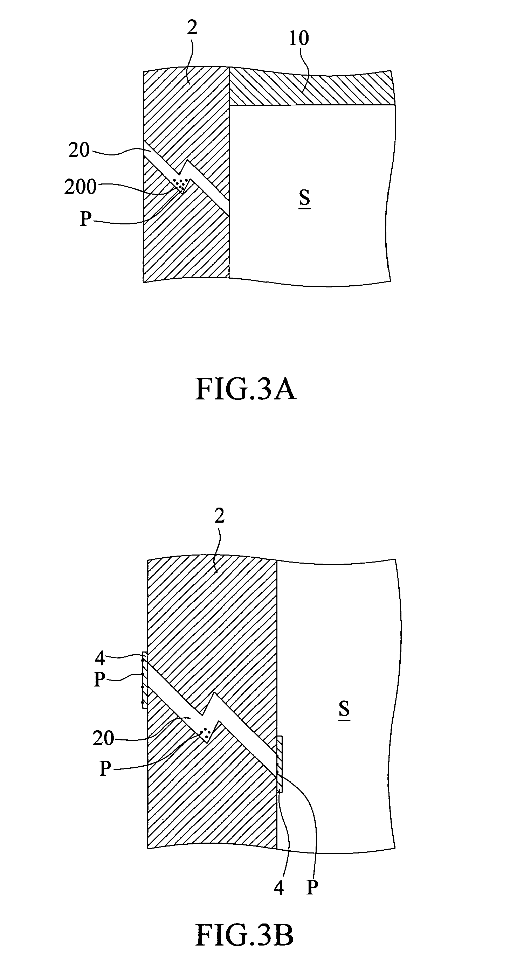

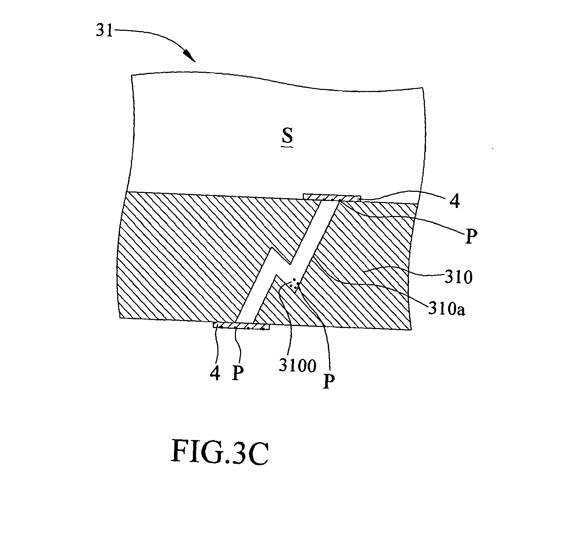

FIGs. 3A, 3B and 3C show the concentrated photovoltaic module according to different embodiments of the present invention. Referring to FIG. 3A, in this embodiment, each of the openings 20 has at least a bend, and the bend has a sag 200 for holding dust P, thereby preventing entry of the dust P into the receiving space S which might otherwise adversely affect the internal cleanness of the concentrated photovoltaic module. In other embodiments, each of the openings 20 has a dust collector made of an adhesive, for example, such that the dust P can be attached thereto. Referring to FIG. 3B, each of the openings 20 can be covered with a filtering member 4, such as a nano-mesh, for preventing relatively large particles of the dust P from entering the openings 20 and the receiving space S, while relatively small particles of the dust P stop at the sag 200 and stay therein. Thus, the aforesaid dustproof effect is enhanced by the dual dustproof mechanisms.

Referring to FIG. 3C, each of the through holes 310a has at least a bend, and the bend has a sag 3100 for holding the dust P, thereby preventing the dust P from entering the receiving space S where it might otherwise adversely affect the internal cleanness of the photovoltaic module. In other embodiments, each of the through holes 310a has a dust collector made of an adhesive, for example, such that the dust P can be attached thereto. Each of the through holes 310a is covered with a filtering member 4 for enhancing the dustproof effect. The above-described filtering member is merely an example and thus can be replaced with filtering members of other types.

According to the present invention, the openings of the side plates or the through holes of the solar cell assembly are configured for removal of moisture. As a result, water vapor is discharged from the receiving space through the openings of the side plates or the openings of the solar cell assembly to thereby prevent the photoelectric conversion taking place in the solar cell assembly from being adversely affected by the water vapor otherwise present in the receiving space, thereby reducing the possibility of damage being caused to the solar cell assembly and prolonging the service life of the concentrated photovoltaic module.

The above-described descriptions of the detailed embodiments are intended to illustrate the preferred implementation of the present invention but are not intended to limit the scope of the present invention. Accordingly, persons skilled in the art can make many modifications and variations to the embodiments and yet still fall within the scope of present invention as defined by the appended claims.

## Claims

1. A concentrated photovoltaic module, comprising:
a carrier formed from a plurality of rods connected with each other, the rods defining a plurality of side areas, a top area, and a bottom area of the carrier;
a plurality of side plates for covering the side areas, respectively, to thereby be coupled to the carrier, the side plates having a plurality of openings penetrating the side plates; and
a light-collecting unit comprising a lens assembly disposed at the top area of the carrier and a solar cell assembly disposed at the bottom area of the carrier and corresponding in position to the lens assembly such that sunlight is allowed to be focused on the solar cell assembly by the lens assembly, the light-collecting unit defining a receiving space in conjunction with the side plates, wherein moisture within the receiving space can be discharged from the receiving space through the openings of the side plates, and the solar cell assembly being further provided with a plurality of through holes.

2. The module of claim 1, wherein the side areas, the top area, and the bottom area of the carrier are of a rectangular shape.

3. The module of claim 2, wherein the lens assembly has a plurality of protruding portions, and the rods have a plurality of concave portions for engaging with the protruding portions.

4. The module of claim 2, wherein the lens assembly has a plurality of concave portions, and the rods have a plurality of protruding portions for engaging with the concave portions.

5. The module of claim 1, wherein the rods are aluminum extruded rods.

6. The module of claim 1, wherein the side plates are made of plastic.

7. The module of claim 1, wherein each of the openings has at least a bend.

8. The module of claim 7, wherein the bend has a sag.

9. The module of claim 8, wherein each of the openings has a dust collector.

10. The module of claim 1, wherein each of the openings has a dust collector.

11. The module of claim 1, wherein the photovoltaic cell assembly is further provided thereunder with a heat-dissipating member.

12. The module of claim 1, further comprising a filtering member disposed on each of the openings and each of the through holes and configured to cover each of the openings.
